**Europäisches Patentamt**

**European Patent Office**

**Office européen des brevets**

(19)

(11) Veröffentlichungsnummer : **0 361 193 B1**

(12) # EUROPÄISCHE PATENTSCHRIFT

(45) Veröffentlichungstag der Patentschrift :
**12.08.92 Patentblatt 92/33**

(51) Int. Cl.⁵ : **H05K 1/00,** H05K 3/40,
H05K 3/42

(21) Anmeldenummer : **89116802.3**

(22) Anmeldetag : **11.09.89**

(54) **Leiterplatte mit einem spritzgegossenen Substrat.**

(30) Priorität : **30.09.88 DE 3833353**

(43) Veröffentlichungstag der Anmeldung :
**04.04.90 Patentblatt 90/14**

(45) Bekanntmachung des Hinweises auf die
Patenterteilung :
**12.08.92 Patentblatt 92/33**

(84) Benannte Vertragsstaaten :
**AT BE CH DE FR GB IT LI NL SE**

(56) Entgegenhaltungen :
FR-A- 2 055 632
FR-A- 2 349 255
US-A- 3 924 794
US-A- 4 532 152

(73) Patentinhaber : **SIEMENS
AKTIENGESELLSCHAFT
Wittelsbacherplatz 2
W-8000 München 2 (DE)**

(72) Erfinder : **Schmidt, Hans-Friedrich, Dr.
Graf-Tattenbach-Weg 3
W-8191 Eurasburg (DE)**

## Beschreibung

Die Erfindung betrifft eine Leiterplatte mit einem spritzgegossenen Substrat, in dessen Oberfläche das Leiterbild durch grabenförmige Vertiefungen im Bereich von Leiterbahnen und durch flächige Vertiefungen im Bereich von Durchkontaktierungen und/oder Anschlußflächen ausgespart ist und die ausgesparten Bereiche einen leitenden Metallüberzug aufweisen. Die Erfindung betrifft ferner ein spritzgegossenes Substrat für eine Leiterplatte, in dessen Oberfläche grabenförmige Vertiefungen im Bereich von Spätern Leiterbahnen und flächige Vertiefungen im Bereich von späteren Durchkontaktierungen und/oder Anschlußflächen eingebracht sind.

Derartige Leiterplatten mit spritzgegossenen oder ähnlich geformten Substraten sind bereits aus der DE-A-27 15 875 bzw. der korrespondierenden CA-A-107 58 25 oder auch aus der US-A-4 53 21 52 bekannt.

Zur Herstellung der beispielsweise aus der DE-A-27 15 875 bekannten Leiterplatte wird zunächst in einer Form das Substrat gebildet, in welchem das Leiterbild und Durchkontaktierungslöcher in Form von Vertiefungen enthalten sind. Nach einer mechanischen und/oder chemischen Oberflächenbehandlung wird dann das Substrat chemisch aktiviert, worauf die erhabenen Flächen des Substrats mit einer Schutzschicht bedeckt werden. Bei dem Aufbringen dieser Schutzschicht müssen lediglich die Vertiefungen freibleiben, so daß eine aufwendige Fotostrukturierung des Resists entfallen kann und der Auftrag beispielsweise mit einer Rakel oder durch Rollbeschichtung, dem sogenannten Roller-Coating, vorgenommen werden kann. Anschließend wird dann vorzugsweise durch stromlose Metallabscheidung ein leitender Metallüberzug aufgebracht, der in den Vertiefungen des Substrats und in den Durchkontaktierungslöchern zur Bildung der gesamten Leiterkonfiguration führt. Zur Fertigstellung der Leiterplatten wird dann auf die Leiterflächen, die keine Lötverbindungen eingehen sollen, ein Lötstopplack aufgebracht.

Es ist ersichtlich, daß durch die Strukturierung des Substrats vor der selektiven Metallisierung keine Fotostrukturierung des entsprechenden Resists erforderlich ist. Demgegenüber erfordert dann aber das Aufbringen des Lötstopplacks entweder ein selektives Auftragen auf die Leiterbahnen oder eine Fotostrukturierung, da die flächigen Vertiefungen welche die Durchkontaktierungen als Lötaugen umgeben oder die als Anschlußflächen dienen sollen freibleiben müssen.

Der Erfindung liegt die Aufgabe zugrunde, eine Leiterplatte mit einem spritzgegossenen Substrat zu schaffen, bei welcher das Aufbringen des Lötstopplacks ohne Fotostrukturierung auf einfache Weise vorgenommen werden kann.

Diese Aufgabe wird bei einer Leiterplatte der eingangs genannten Art erfindungsgemäß dadurch gelöst, daß die flächigen Vertiefungen tiefer sind als die grabenförmigen Vertiefungen und das der Metallüberzug in den grabenförmigen Vertiefungen zumindest annähernd bis zur Oberfläche des Substrats reicht.

Der Erfindung liegt die Erkenntnis zugrunde, daß durch eine Geometrie des Substrats mit flächigen Vertiefungen die tiefer sind als die grabenförmigen Vertiefungen die Metallabscheidung dann zu einem Auffüllen der grabenförmigen Vertiefungen bis zur Oberfläche führen kann, während das gleichzeitig in den flächigen Vertiefungen abgeschiedene Metall demgemäß nicht bis zur Oberfläche reicht. Dies hat dann aber andererseits zur Folge, daß bei einem flächigen Auftragen des Lötstopplacks mit einer Rakel, durch Roller-Coating oder dergleichen die Leiterbahnen sicher geschützt werden, während die flächigen Vertiefungendie ja gerade Lötaugen oder Löt-Pads bilden sollen - freibleiben und insbesondere durch Heißverzinnen zusammen mit den Wandungen der Durchkontaktierungslöcher mit einer Lotschicht überzogen werden können.

Bei der erfindungsgemäßen Leiterplatte wird der Metallüberzug vorzugsweise durch chemisch aufgebrachtes Kupfer gebildet, daß ja dann wie bereits erwähnt wurde im Bereich von Lötaugen, Löt-Pads und Durchkontaktierungslöchern mit einer geeigneten Lotschicht, insbesondere Zinn, überzogen wird.

Die Erfindung gibt auch ein spritzgegossenes Substrat für eine Leiterplatte an, bei welchem im Einklang mit den vorstehenden Ausführungen die flächigen Vertiefungen tiefer sind als die grabenförmigen Vertiefungen. Vorzugsweise wird dann das Substrat so hergestellt, daß die Tiefe der flächigen Vertiefungen mindestens um einen Faktor 1,5 größer ist, als die Tiefe der grabenförmigen Vertiefungen. Bei einer derartigen Bemessung ist dann mit Sicherheit gewährleistet, daß beim Roller-Coating des Lötstopplacks der Metallüberzug in den flächigen Vertiefungen absolut freibleibt.

Ein Ausführungsbeispiel der Erfindung ist in der Zeichnung dargestellt und wird im folgenden näher beschrieben.

Es zeigen

Fig. 1 einen Schnitt durch einen Teil einer Leiterplatte mit einer erfindungsgemäßen Geometrie des spritzgegossenen Substrats und

Fig. 2 bis 6 die wesentlichen Verfahrensstadien bei der Herstellung einer Leiterplatte gemäß Fig. 1.

Vor der detaillierten Beschreibung ist noch darauf hinzuweisen, daß der Begriff "Leiterplatte" und auch die vereinfachte Zeichnung zunächst auf ein flächiges Gebilde schließen lassen. Die Vorteile der spritzgegossenen Substrate und des ohne Fotostrukturierungen möglichen Aufbringens eines Plating-Resists und des Lötstopplacks sind jedoch genau darin zu sehen, daß von der ebenen Form abgewichen werden kann und dreidimensionale Leiterplatten mit beliebigen abgewinkelten oder gekrümmten Formen hergestellt werden können.

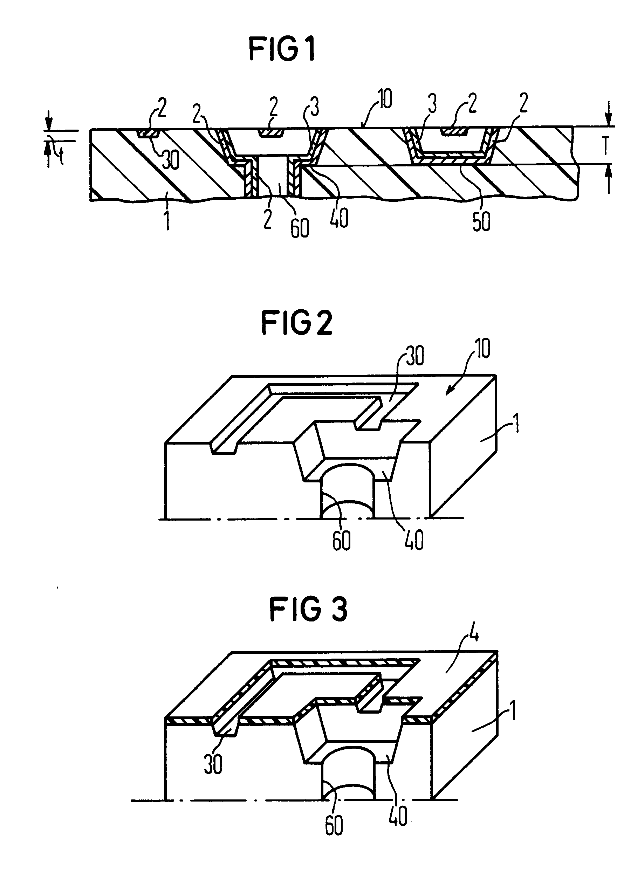

Fig. 1 zeigt einen Schnitt durch einen Teil eines beispielsweise aus glasfaserverstärktem Polyetherimid bestehenden Substrats 1. In dieses Substrat 1 wurden bereits beim Spritzgießvorgang grabenförmige Vertiefungen 30 der Tiefe t, im Bereich von Durchkontaktierungslöchern 60 liegende flächenförmige Vertiefungen 40 der Tiefe T und an anderen Stellen flächenförmige Vertiefungen 50 der gleichen Tiefe T erzeugt. Es ist zu erkennen, daß ein Metallüberzug 2, dessen Stärke der Tiefe t entspricht, die grabenförmigen Vertiefungen 30 bis zur Oberfläche 10 des Substrats 1 ausfüllt und dadurch die Leiterbahnen bildet. Demgegenüber reicht der Metallüberzug 2 auf den flächigen Vertiefungen 40 und 50 nur im Wandungsbereich bis zur Oberfläche 10, während im Bodenbereich ein deutlicher Abstand bis zur Oberfläche 10 verbleibt. Ist beispielsweise die Tiefe $T = 2t$, so verbleibt in den flächigen Vertiefungen 40 und 50 zwischen dem Metallüberzug 2 und der Oberfläche 10 ein Abstand, welcher der Tiefe t entspricht. Dieser Abstand muß aber auf jeden Fall so groß sein, daß bei einer flächigen Beschichtung der Oberfläche 10 mit einem Lötstopplack nur die Leiterbahnen im Bereich der grabenförmigen Vertiefungen 30 aber keineswegs die Lötaugen im Bereich der flächigen Vertiefungen 40 und die Anschlußflächen im Bereich der flächigen Vertiefungen 50 abgedeckt werden. Nach diesem aus Fig. 1 nicht ersichtlichen Aufbringen eines Lötstoplacks können dann die als Durchkontaktierungen, Lötaugen und Anschlußflächen dienenden Bereiche der Metallschicht 2 durch Heißverzinnen mit einer Zinnschicht 3 überzogen werden.

Bei der Herstellung der Leiterplatten wird von einem Substrat 1 ausgegangen, welches als Spritzgußteil in dem Beispiel gemäß Fig. 2 die grabenförmigen Vertiefungen 30 entsprechend dem Leiterbild, die flächigen Vertiefungen 40 und die davon ausgehenden Durchkontaktierungslöcher 60 enthält. Auf die Oberfläche 10 dieses Substrats 1 wird dann nach einer üblichen Oberflächenbehandlung gemäß Fig. 3 eine Lackschicht 4 aufgebracht, bei welcher es sich um ein übliches Plating-Resist handelt. Das Aufbringen der Lackschicht 4 erfolgt durch Roller-Coating, wobei die Vertiefungen 30 und 40 freibleiben.

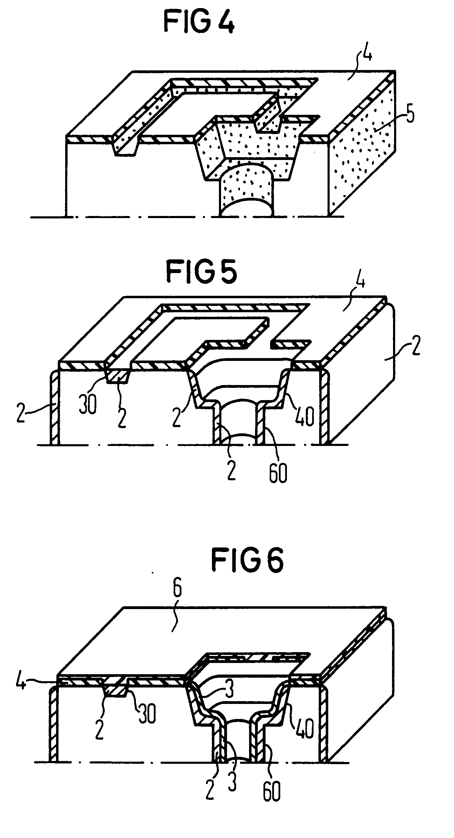

Gemäß Fig. 4 wird nachfolgend eine Bekeimung 5 aufgebracht, die in der Zeichnung durch feine Punkte angedeutet ist. Das Aufbringen dieser Bekeimung 5 erfolgt beispielsweise durch Eintauchen des Substrats 1 in ein $PdCl_2$-$SnCl_2$-Bad.

Nach dem Aufbringen der Bekeimung 5 wird diese aktiviert, wobei es sich hier um ein in der Additivtechnik übliches Reduzieren bzw. Beschleunigen handelt. Anschließend wird gemäß Fig. 5 auf die nicht durch eine Lackschicht 4 geschützten Bereiche durch außenstromlose, chemische Metallabscheidung die Metallschicht 2 aufgebracht. Es ist ersichtlich, daß diese in einem handelsüblichen stromlosen Kupferbad aufgebrachte Metallschicht 2 durch eine entsprechende Bemessung der Beschichtungsdauer eine Stärke erreicht hat, die einer vollständigen Ausfüllung der grabenförmigen Vertiefungen 30 bis zur Substratoberfläche entspricht.

Anschließend wird dann gemäß Fig. 6 durch Roller-Coating ein Lötstopplack 6 aufgetragen, welcher die flächigen Vertiefungen 40 und die Durchkontaktierungslöcher 60 freiläßt und dort das Auftragen der Zinnschicht 3 durch Heißverzinnen ermöglicht. Es ist zu erkennen, daß vor dem Aufbringen des Lötstopplacks 6 die Lackschicht 4 nicht entfernt werden muß.

**Patentansprüche**

1. Leiterplatte mit einem spritzgegossenen Substrat (1), in dessen Oberfläche (10) das Leiterbild durch grabenförmige Vertiefungen (30) im Bereich von Leiterbahnen und durch flächige Vertiefungen (40,50) im Bereich von Durchkontaktierungen und/oder Anschlußflächen ausgespart ist und die ausgesparten Bereiche einen leitenden Metallüberzug (2) aufweisen,
**dadurch gekennzeichnet,**
daß die flächigen Vertiefungen (40,50) tiefer sind als die grabenförmigen Vertiefungen (30) und daß der Metallüberzug (2) in den grabenförmigen Vertiefungen (30) zumindest annähernd bis zur Oberfläche (10) des Substrats (1) reicht.

2. Leiterplatte nach Anspruch 1,
**dadurch gekennzeichnet,**
daß der Metallüberzug (2) im Bereich der flächigen Vertiefungen (40,50) mit einer durch Heißverzinnen aufgebrachten Zinnschicht (3) überzogen ist.

3. Leiterplatte nach Anspruch 1 oder 2,
**dadurch gekennzeichnet,**
daß der Metallüberzug (2) durch chemisch aufgebrachtes Kupfer gebildet ist.

4. Spritzgegossenes Substrat (1) für eine Leiterplatte, in dessen Oberfläche (10) grabenförmige Vertiefungen (30) im Bereich von späteren Leiterbahnen und flächige Vertiefungen (40,50) im bereich von späteren Durchkontaktierungen und/oder Anschlußflächen eingebracht sind,

**dadurch gekennzeichnet,**

daß die flächigen Vertiefungen (40,50) tiefer sind als die grabenförmigen Vertiefungen (30).

5. Spritzgegossenes Substrat (1) nach Anspruch 4,

**dadurch gekennzeichnet,**

daß die Tiefe (T) der flächigen Vertiefungen (40,50) mindestens um einen Faktor 1,5 größer ist, als die Tiefe (t) der grabenförmigen Vertiefungen (30).

## Claims

1. Printed circuit board comprising an injection-moulded substrate (1) in whose surface (10) the conductor pattern is recessed by trench-like depressions (30) in the region of conductor tracks and by flat-area depressions (40, 50) in the region of through connections and/or connecting pads and the recessed regions have a conducting metal coating (2),

**characterised in that**

the flat-area depressions (40, 50) are deeper than the trench-like depressions (30) and in that the metal coating (2) in the trench-like depressions (30) extends at least approximately to the surface (10) of the substrate (1).

2. Printed circuit board according to Claim 1,

**characterised in that**

the metal coating (2) in the region of the flat-area depressions (40, 50) is coated with a tin layer (3) deposited by hot tinning.

3. Printed circuit board according to Claim 1 or 2,

**characterised in that**

the metal coating (2) is electrolessly deposited copper.

4. Injection-moulded substrate (1) for a printed circuit board into whose surface (10) trench-like depressions (30) in the region of future conductor tracks and flat-area depressions (40, 50) in the region of future through connections and or connection pads have been introduced,

**characterised in that**

the flat-area depressions (40, 50) are deeper than the trench-like depressions (30).

5. Injection-moulded substrate (1) according to Claim 4,

**characterised in that**

the depth (T) of the flat-area depressions (40, 50) is at least a factor of 1.5 greater than the depth (t) of the trench-like depressions (30).

## Revendications

1. Plaquette à circuits imprimés comportant un substrat (1) moulé par injection, dans la surface (10) duquel la configuration des conducteurs est évidée au moyen de renfoncements en forme de sillons (30) dans la zone de voies conductrices et par des renfoncements d'une certaine étendue (40,50) dans la zone de contacts traversants et/ou de surfaces de raccordement, et les zones évidées possèdent un revêtement métallique conducteur (2),

**caractérisée par**

le fait que les renfoncements (40,50) d'une certaine étendue sont plus profonds que les renfoncements en forme de sillons (30) et que le revêtement métallique (2) situé dans les renfoncements en forme de sillons (30) s'étend au moins approximativement jusqu'à la surface (10) du substrat (1).

2. Plaquette à circuits imprimés suivant la revendication 1,

**caractérisée par**

le fait que le revêtement métallique (2) est recouvert, dans la zone des renfoncements (40,50), d'une certaine étendue, par une couche d'étain (3) déposée par étamage à chaud.

3. Plaquette à circuits imprimés suivant la revendication 1 ou 2,

**caractérisée par**

le fait que le revêtement métallique (2) est formé par du cuivre déposé chimiquement.

4. Substrat (1) moulé par injection pour une plaquette à circuits imprimés, dans la surface (10) de laquelle sont ménagés des renfoncements en forme de sillons (30) dans la zone de voies conductrices formées ultérieurement, et des renfoncements (40,50) d'une certaine étendue dans la zone de contacts traversants et/ou de surfaces de raccordement, formés ultérieurement,

**caractérisé par**

le fait que les renfoncements (40,50) d'une certaine étendue sont plus profonds que les renfoncements en forme de sillons (30).

5. Substrat (1) moulé par injection selon la revendication 4,

**caractérisé par**

le fait que la profondeur (T) des renfoncements (40,50) d'une certaine étendue est supérieure, d'un facteur égal à 1,5, à la profondeur (t) des renfoncements en forme de sillons (30).

# FIG 1

# FIG 2

# FIG 3

## FIG 4

## FIG 5

## FIG 6